(19) Europäisches Patentamt
European Patent Office
Office européen des brevets

(11) **EP 4 098 768 A1**

(12) **EUROPEAN PATENT APPLICATION**
published in accordance with Art. 153(4) EPC

(43) Date of publication:
**07.12.2022 Bulletin 2022/49**

(21) Application number: **20873356.8**

(22) Date of filing: **22.12.2020**

(51) International Patent Classification (IPC):
**C23C 14/24** (2006.01)

(52) Cooperative Patent Classification (CPC):
**C23C 14/08; C23C 14/044; C23C 14/243;
C23C 14/30; C23C 14/562; H01M 4/0423;
H01M 4/1391; H01M 10/052; H01M 10/0562;
H01M 10/0585;** H01M 4/0404; H01M 4/525;
H01M 2300/0068; Y02E 60/10; Y02P 70/50

(86) International application number:
**PCT/JP2020/047930**

(87) International publication number:
**WO 2021/153104 (05.08.2021 Gazette 2021/31)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.01.2020 JP 2020011830**

(71) Applicant: **ULVAC, Inc.
Chigasaki-shi, Kanagawa 253-8543 (JP)**

(72) Inventors:
• **GIBO, Manabu
  Chigasaki-shi, Kanagawa 253-8543 (JP)**
• **EHIRA, Hiroshi
  Chigasaki-shi, Kanagawa 253-8543 (JP)**
• **SAKAMOTO, Junichi
  Chigasaki-shi, Kanagawa 253-8543 (JP)**

(74) Representative: **Zacco GmbH
Bayerstrasse 83
80335 München (DE)**

(54) **EVAPORATION SOURCE AND EVAPORATOR**

(57)    The invention provides an evaporator that is heated by an electron beam in vacuum, evaporates or sublimates a vapor-deposition material, and forms a lithium-containing compound coating on a surface of a substrate in transfer by codeposition. The evaporator includes a hearth liner that includes a cooler; and a plurality of liners that are accommodated in the hearth liner, each of which has the vapor-deposition material thereinside.

FIG. 1

**Description**

TECHNICAL FIELD

The present invention relates to an evaporator and a deposition apparatus and particularly relates to a preferred technique when deposition is carried out by use of codeposition.

This application claims priority from Japanese Patent Application No. 2020-011830 filed on January 28, 2020, the contents of which are incorporated herein by reference in their entirety.

BACKGROUND ART

Various researches on lithium-ion batteries have been conducted. Particularly, as batteries that combine safety, high energy density, and a long product life, development of all-solid-state batteries that are constituted of a negative electrode, an electrolyte, and a positive electrode which are all formed in a solid state has been expected.

A thin film that serves as a negative electrode, an electrolyte layer, and a positive electrode and is formed of a lithium-containing compound such as $LiCoO_2$ (LCO), LiPON, a Li compound, or the like is formed in the above-described batteries.

As a method of forming a thin film, vapor deposition is carried out by resistance heating deposition or electron beam deposition in a deposition apparatus. In such method of forming a thin film, in order to cause the film characteristics such as ion conductivity or crystallinity to be a predetermined condition, strict control of the film composition is required.

However, in the case of forming a thin film by use of a compound containing a plurality of chemical elements which serve as evaporators and are mixed therein, due to a difference in vapor pressures of the chemical elements, the formed thin film has the film composition different from that of the target thin film.

The chemical element having a low vapor pressure evaporates faster than the chemical element having a high vapor pressure. Therefore, for example, in an early phase of the deposition, a lithium-rich film composition is obtained, and thereafter, as the time elapses from the early phase, lithium is depleted.

Particularly, in the case of sequentially forming a film on a substrate (base member) transferred by roll-to-roll or by sheet-to-sheet apparatus, the above difference in composition cannot be ignored.

Consequently, as disclosed in Patent Document 1, formation of an electrolyte layer by codeposition using a plurality of sources (evaporators) has been studied. In such codeposition, for example, a positive electrode film made of $LiCoO_2$ (LCO) is formed by use of an evaporator containing lithium and an evaporator containing cobalt, or an electrolyte layer made of LiPON is formed by use of an evaporator containing lithium and an evaporator containing phosphorus.

PRIOR ART DOCUMENTS

PATENT DOCUMENTS

[Patent Document 1] Japanese Unexamined Patent Application, First Publication No. 2003-277917

SUMMARY OF THE INVENTION

PROBLEMS TO BE SOLVED BY THE INVENTION

However, in the technique disclosed in Patent Document 1, a desired film composition and a film quality depending on the composition may not be obtained, and therefore there is the following demand.

Since the distances from a plurality of evaporators to a deposition position are different from each other, it is difficult to obtain a film composition having a desired condition.

At the heating, it is necessary to prevent a high-temperature vapor-deposition material from reacting with a wall portion of a liner container that contains the material.

It is preferable that the surface area of a melted vapor-deposition material be larger when deposition is carried out. However, in this case, it is necessary to prevent the reaction to the aforementioned liner container wall or contamination of the other deposition material.

The invention was made in view of the above-described situation, and achieves the following objects.

1. Improvement of controllability of a film composition in codeposition.
2. Limitation of an increase in temperature of a liner container wall containing a vapor-deposition material.
3. Achievement of heating a vapor-deposition material by applying high power thereto.

MEANS FOR SOLVING THE PROBLEMS

An evaporator of the invention that is heated by an electron beam in vacuum, evaporates or sublimates a vapor-deposition material, and forms a lithium-containing compound coating on a surface of a substrate in transfer by codeposition, the evaporator includes: a hearth liner that includes a cooler; and a plurality of liners that are accommodated in the hearth liner, each of which has the vapor-deposition material thereinside. According to the invention, the above-described problem is solved.

In the evaporator of the invention, each of the liners may have a wall facing a surrounding member that serves as an adjacent liner or the hearth liner, and the liners may be disposed inside the hearth liner such that the wall comes into contact with the surrounding member in a heated state and such that the wall is separated from the surrounding member with a gap interposed therebetween in a non-heated state.

In the evaporator of the invention, each of the liners may be formed in a rectangular shape in plan view, and the liners may be disposed inside the hearth liner and adjacent to each other in a direction orthogonal to a movement direction of the substrate.

In the evaporator of the invention, a material used to form each of the liners may be a material that does not react with the vapor-deposition material in a heated state.

In the evaporator of the invention, of the liners, a liner accommodating lithium as the vapor-deposition material may be formed of tantalum.

In the evaporator of the invention, of the liners, a liner accommodating the vapor-deposition material not containing lithium may be formed of copper.

In the evaporator of the invention, of the liners, a liner accommodating the vapor-deposition material containing lithium may be formed of tantalum.

In the evaporator of the invention, of the liners, a liner accommodating the vapor-deposition material containing lithium may be formed of copper.

In the evaporator of the invention, of the liners, a liner formed of copper may be disposed inside the hearth liner, and in a non-heated state, a ratio of a size of the gap to an outer size of the liner may be in the range of 0.0007 to 0.00839.

In the evaporator of the invention, of the liners, a liner formed of tantalum may be disposed inside the hearth liner, and in a non-heated state, a ratio of a size of the gap to an outer size of the liner may be in the range of 0.0007 to 0.0032.

In the evaporator of the invention, of the liners, five liners formed of copper may be disposed inside the hearth liner, in a non-heated state, a ratio of a sum of sizes of the gaps to a sum of outer sizes of the liners in a liner arrangement direction may be in a range of 0.0035 to 0.042.

In the evaporator of the invention, of the liners, three liners formed of copper and two liners formed of tantalum may be disposed inside the hearth liner, in a non-heated state, a ratio of a sum of sizes of the gaps to a sum of outer sizes of the liners in a liner arrangement direction may be in a range of 0.0035 to 0.0316.

In the evaporator of the invention, of the liners, two liners formed of copper and three liners formed of tantalum may be disposed inside the hearth liner, in a non-heated state, a ratio of a sum of sizes of the gaps to a sum of outer sizes of the liners in a liner arrangement direction may be in a range of 0.0035 to 0.0264.

In the evaporator of the invention, of the liners, five liners formed of tantalum may be disposed inside the hearth liner, in a non-heated state, a ratio of a sum of sizes of the gaps to a sum of outer sizes of the liners in a liner arrangement direction may be in a range of 0.0035 to 0.016.

In the evaporator of the invention, the upper edges of the liners disposed inside the hearth liner may be on the same plane.

A deposition apparatus of the invention includes: a chamber in which a substrate is movable in vacuum; a substrate transfer unit that transfers the substrate; the above-described evaporator; and an electron beam source that irradiates the evaporator with an electron beam.

The evaporator of the invention which is heated by an electron beam in vacuum, evaporates or sublimates a vapor-deposition material, and forms a lithium-containing compound coating on a surface of a substrate in transfer by codeposition, the evaporator includes: a hearth liner that includes a cooler; and a plurality of liners that are accommodated in the hearth liner, each of which has the vapor-deposition material thereinside.

Consequently, by using a plurality of liners accommodating vapor-deposition materials different from each other, and by carrying out vapor-deposition in a state where the hearth liner is cooled down by the cooler, codeposition can be carried out. At this time, the vapor-deposition material at the portion close to the center of the liner is heated by the electron beam to a temperature necessary for codeposition. At the same time, the portion close to the wall portion of the liner is cooled down by the hearth liner that is in contact with the liner. For this reason, the temperatures of the vapor-deposition material and the wall of the liner do not increase to the temperature at which they chemically react with each other.

In the evaporator of the invention, the liners are disposed inside the hearth liner such that the wall portion thereof comes into contact with the periphery in a heated state and so as to have a gap therebetween in a non-heated state.

In other words, each of the liners has a wall facing a surrounding member that serves as an adjacent liner or the hearth liner, and the liners are disposed inside the hearth liner such that the wall comes into contact with the surrounding member in a heated state and such that the wall is separated from the surrounding member with a gap interposed therebetween in a non-heated state.

Therefore, in the heated state of the vapor-deposition, the wall of the liner comes into contact with the surrounding member, and a thermal conduction state required for sufficient cooling can be maintained.

Here, "the wall of the liner comes into contact with the surrounding member in the heated state" means that, in a state where all of the liners are disposed inside the hearth liner, the wall portions of the liners which face each other and are disposed at the positions adjacent to each other come into contact with each other or means that the wall of the liner and the wall portion of the hearth liner which face each other come into contact with each other.

Furthermore, "the wall of the liner comes into contact with the surrounding member in the heated state" means that it has to at least have the portion at which they come into contact with each other. Moreover, the member that is located at the periphery of the liner and is contactable to the wall of the liner in the heated state may be referred to as the surrounding member.

Additionally, "the surrounding member next to the wall of the liner has a gap therebetween in the non-heated state" means that, in a state where all of the liners are disposed inside the hearth liner, a gap is present between the wall portions of the liners which face each other and are disposed at the positions adjacent to each other or means that a gap is present between the wall of the liners which face each other and the wall portion of the hearth liner.

In the evaporator of the invention, each of the liners is formed in a rectangular shape in plan view, and the liners are disposed inside the hearth liner and adjacent to each other in a direction orthogonal to a movement direction of the substrate.

Consequently, with respect to the film formation region (vapor-deposition region) of the substrate that transfers from the plurality of liners, the vapor-deposition material having an amount necessary therefor evaporates, and codeposition can be carried out so as to obtain a target film composition.

In the evaporator of the invention, a material used to form each of the liners is a material that does not react with the vapor-deposition material in a heated state.

For this reason, since cooling is carried out by the cooler and the surface area necessary for sufficient thermal conduction is ensured even in the heated state, an increase in temperature of the wall of the liner is limited, and chemical reaction to the vapor-deposition material does not occur in a state where the increase in temperature is limited. Accordingly, it is possible to prevent the vapor-deposition material from reacting with the wall of the liner.

In the evaporator of the invention, of the liners, a liner accommodating lithium as the vapor-deposition material is formed of tantalum.

Therefore, the reaction of the vapor-deposition material to the wall of the liner due to an increases in the temperature of the vapor-deposition material in the heated state can be prevented and furthermore heat can be sufficiently transmitted, cooling is carried out by the cooler, and therefore an increase in temperature of the wall of the liner is limited.

In the evaporator of the invention, of the liners, a liner accommodating the vapor-deposition material not containing lithium is formed of copper.

Consequently, the reaction of the vapor-deposition material to the wall of the liner due to an increases in the temperature of the vapor-deposition material in the heated state can be prevented and furthermore heat can be sufficiently transmitted, cooling is carried out by the cooler, and therefore an increase in temperature of the wall of the liner is limited.

In the evaporator of the invention, of the liners, a liner accommodating the vapor-deposition material containing lithium is formed of tantalum.

Because of this, the reaction of the vapor-deposition material to the wall of the liner due to an increases in the temperature of the vapor-deposition material in the heated state can be prevented and furthermore heat can be sufficiently transmitted, cooling is carried out by the cooler, and therefore an increase in temperature of the wall of the liner is limited.

In the evaporator of the invention, of the liners, a liner accommodating the vapor-deposition material containing lithium is formed of copper.

Therefore, the reaction of the vapor-deposition material to the wall of the liner due to an increases in the temperature of the vapor-deposition material in the heated state can be prevented and furthermore heat can be sufficiently transmitted, cooling is carried out by the cooler, and therefore an increase in temperature of the wall of the liner is limited.

In the evaporator of the invention, of the liners, a liner formed of copper is disposed inside the hearth liner, and in a non-heated state, a ratio of a size of the gap to an outer size of the liner is in the range of 0.0007 to 0.00839.

Consequently, in the vapor-deposition state (in the heated state) of the heating temperature at which the vapor-deposition material is heated, the side wall of the liner is thermally-expanded depending on the material of the liner, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, of the liners, a liner formed of tantalum is disposed inside the hearth liner, and in a non-heated state, a ratio of a size of the gap to an outer size of the liner is in the range of 0.0007 to 0.0032.

Accordingly, in the vapor-deposition state (in the heated state) of the heating temperature at which the vapor-deposition material is heated, the side wall of the liner is thermally-expanded depending on the material of the liner, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, of the liners, five liners formed of copper are disposed inside the hearth liner, in a non-heated state, a ratio of a sum of sizes of the gaps to a sum of outer sizes of the liners in a liner arrangement direction is in a range of 0.0035 to 0.042.

Because of this, in the vapor-deposition state (in the heated state) of the heating temperature at which the vapor-deposition material is heated, the side wall of the liner is thermally-expanded depending on the material of the liner, the walls of the liners which are located at the adjacent positions and face each other come into contact with each other, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, of the liners, three liners formed of copper and two liners formed of tantalum are disposed inside the hearth liner, in a non-heated state, a ratio of a sum of sizes of the gaps to a sum of outer sizes of the liners in a liner arrangement direction is in a range of 0.0035 to 0.0316.

For this reason, in the vapor-deposition state (in the heated state) of the heating temperature at which the vapor-deposition material is heated, the side wall of the liner is thermally-expanded depending on the material of the liner, the walls of the liners which are located at the adjacent positions and face each other come into contact with each other, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, of the liners, two liners formed of copper and three liners formed of tantalum are disposed inside the hearth liner, in a non-heated state, a ratio of a sum of sizes of the gaps to a sum of outer sizes of the liners in a liner arrangement direction is in a range of 0.0035 to 0.0264.

Consequently, in the vapor-deposition state (in the heated state) of the heating temperature at which the vapor-deposition material is heated, the side wall of the liner is thermally-expanded depending on the material of the liner, the walls of the liners which are located at the adjacent positions and face each other come into contact with each other, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, of the liners, five liners formed of tantalum are disposed inside the hearth liner, in a non-heated state, a ratio of a sum of sizes of the gaps to a sum of outer sizes of the liners in a liner arrangement direction is in a range of 0.0035 to 0.016.

Accordingly, in the vapor-deposition state (in the heated state) of the heating temperature at which the vapor-deposition material is heated, the side wall of the liner is thermally-expanded depending on the material of the liner, the walls of the liners which are located at the adjacent positions and face each other come into contact with each other, and the wall of the liner and the wall portion of the hearth liner which face each other come into contact with each other. Therefore, since the surface area necessary for sufficient thermal conduction is ensured, an increase in temperature of the wall of the liner is limited, even in the heated state, cooling is carried out by the cooler, and it is possible to prevent the vapor-deposition material having an increased temperature from reacting with the wall of the liner.

In the evaporator of the invention, the upper edges of the liners disposed inside the hearth liner are on the same plane.

Therefore, an undesirable effect is prevented by the edges of the liners from being applied to the vapor-deposition particles directed to the substrate, and the film thickness and the film characteristics can be made uniform.

Additionally, the deposition apparatus of the invention includes: a chamber in which a substrate is movable in vacuum; a substrate transfer unit that transfers the substrate; the above-described evaporator; and an electron beam source that irradiates the evaporator with an electron beam.

Accordingly, a lithium-containing compound film having a target film composition can be formed by codeposition.

Effects of the Invention

According to the invention, the effects can be obtained in that, controllability of a film composition in codeposition is improved, an increase in temperature of a liner container wall containing a vapor-deposition material is limited, and it is possible to heat a vapor-deposition material by applying high power thereto.

BRIEF DESCRIPTION OF THE DRAWINGS

FIG. 1 is a schematic view showing a deposition apparatus according to a first embodiment of the invention.
FIG. 2 is a top view showing an evaporator according to the first embodiment of the invention.
FIG. 3 is a cross-sectional side view showing the evaporator according to the first embodiment of the invention.
FIG. 4 is an explanatory diagram showing an example of an arrangement of the evaporator according to the first embodiment of the invention.
FIG. 5 is an explanatory diagram showing an example of an arrangement of the evaporator according to the first embodiment of the invention.
FIG. 6 is an explanatory diagram showing an example of an arrangement of an evaporator according to a second embodiment of the invention.
FIG. 7 is an explanatory diagram showing an example of an arrangement of the evaporator according to the second embodiment of the invention.

EMBODIMENTS FOR CARRYING OUT THE INVENTION

Hereinafter, a deposition apparatus according to a first embodiment of the invention will be described with reference to drawings.

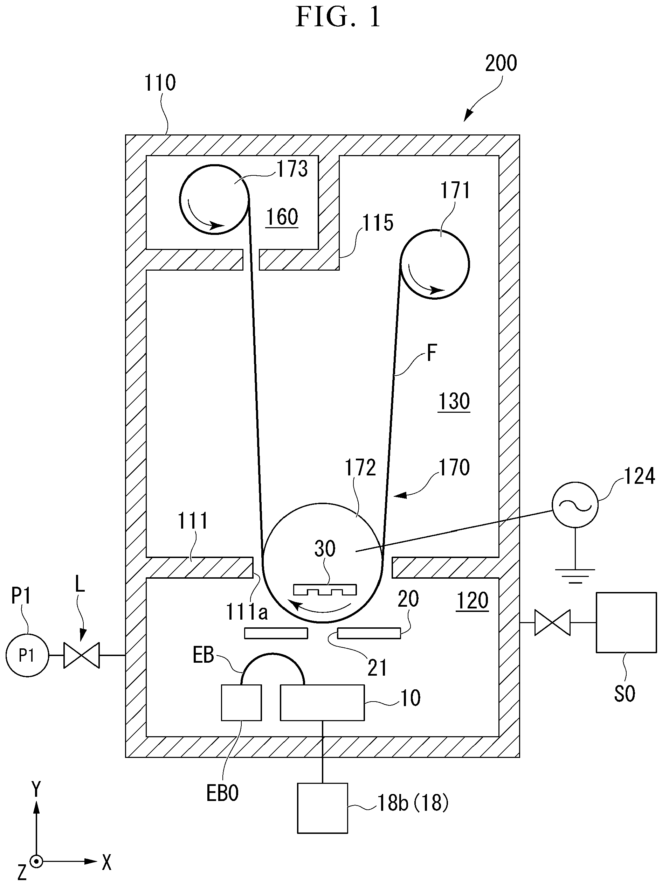

FIG. 1 is a schematic view showing the deposition apparatus, and reference numeral 100 represents a deposition apparatus in FIG. 1. In FIG. 1, the X-axis, Y-axis, and Z-axis directions which are orthogonal to each other indicate three axis directions, the X-axis and the Y-axis indicate a horizontal direction, and the Z-axis direction indicates a vertical direction.
As shown in FIG. 1, the deposition apparatus 100 according to the embodiment includes a vacuum chamber (chamber) 110, a film formation unit 120, a transfer unit (substrate transfer unit) 130, a collection unit (substrate transfer unit) 160, and a transfer mechanism (substrate transfer unit) 170.
The vacuum chamber 110 has a hermetically-sealable structure and is connected to a first discharge line L provided with a vacuum pump P1. Therefore, the vacuum chamber 110 is configured such that the internal side thereof can be discharged so as to be a predetermined reduced-pressure atmosphere and the reduced-pressure atmosphere can be maintained. In addition, as shown in FIG. 1, the vacuum chamber 110 includes a plurality of partition plates 111 and 115 that separate the film formation unit 120, the transfer unit 130, and the collection unit 160 to each other.
The film formation unit 120 is a film formation chamber that is partitioned by the partition plate 111 and the outer wall of the vacuum chamber 110, and an evaporator 10 is provided thereinside. Additionally, the film formation unit 120 is connected to the first discharge line L. Consequently, when the vacuum chamber 110 is vacuumed, firstly, the inside of the film formation unit 120 is vacuumed.
On the other hand, since the film formation unit 120 is communicated with the transfer unit 130, when the inside of the film formation unit 120 is vacuumed, the inside of the transfer unit 130 is also vacuumed. For this reason, a difference in pressure occurs between the film formation unit 120 and the transfer unit 130. Due to the pressure difference, a vaporization flow of raw materials containing lithium which will be described later is prevented from entering the inside of the transfer unit 130. A gas supplier SO that supplies a film forming gas is connected to the film formation unit 120. The gas supplier S0 is configured as a plasma generator. The gas supplier SO can supply a film forming gas containing nitrogen or oxygen.
The evaporator (film-formation source supplier) 10 is an evaporation source that evaporates raw materials containing lithium, for example, is configured by a resistance heating evaporation source, an inductive heating evaporation source, an electron beam heating evaporation source, or the like.
The transfer unit 130 is a transfer chamber that is partitioned by the partition plate 115 and the outer wall of the vacuum chamber 110, and is disposed at the upper portion of the inside of the vacuum chamber 110 in the Y-axis direction. The first discharge line L is only connected to the film formation unit 120 in the embodiment but the transfer unit 130 and the film formation unit 120 may be independently vacuumed by also connecting a separate discharge line to the transfer unit 130.
The transfer mechanism (substrate transfer unit) 170 includes an unwinding roller 171, a main roller 172, and a rewinding roller 173.

Each of the unwinding roller 171, the main roller 172, and the rewinding roller 173 includes a rotation driver that is not shown in the drawings and is configured to be able to rotate in the direction around the Z-axis at a predetermined rate of rotation and in the direction of arrow shown in FIG. 1. Therefore, in the vacuum chamber 110, a base member F (substrate) is fed from the unwinding roller 171 to the rewinding roller 173 at a predetermined feed speed.

The unwinding roller 171 is provided at the upstream side of the film formation unit 120 in the transfer direction of the base member F and has a function of sending the base member F to the main roller 172. Note that, the appropriate number of guide rollers (not shown in the drawings) which do not include an independent rotation driver may be disposed at suitable positions between the unwinding roller 171 and the main roller 172.

The main roller 172 is disposed between the unwinding roller 171 and the rewinding roller 173 in the transfer direction of the base member F. At least part of the bottom portion of the main roller 172 in the Y-axis direction is disposed at the position at which it faces the film formation unit 120 through an opening portion 111a provided at the partition plate 111. The main roller 172 is spaced apart at a predetermined distance, faces the opening portion 111a, and faces the evaporator 10 in the Y-axis direction. The main roller 172 is formed of a metal material such as stainless steel, iron, aluminum, or the like and formed in a cylindrical shape, and, for example, a temperature control mechanism such as a temperature-controlling medium circulation system which is not shown in the drawings may be provided thereinside. The size of the main roller 172 is not particularly limited, and typically, a width size thereof in the Z-axis direction is set to be larger than the width size of the base member F in the Z-axis direction.

The rewinding roller 173 is disposed inside the collection unit 160 that is a space partitioned by the partition plate 115 and the outer wall of the vacuum chamber 110 and has a function of collecting the base member F that is unwound from the unwinding roller 171. An evaporation material containing lithium is deposited on the base member F that has passed through the film formation unit 120 and collected by the rewinding roller 173. The appropriate number of guide rollers (not shown in the drawings) which do not include an independent rotation driver may be disposed at suitable positions between the rewinding roller 173 and the main roller 172. Note that, the partition plate 115 may not be provided.

The base member F is, for example, an elongated film that is cut to have a predetermined width. The base member F is formed of a metal such as copper, aluminum, nickel, stainless steel, or the like. The material of the base member F is not limited to a metal. As the material of the base member F, a resin film may be used such as an OPP (oriented polypropylene) film, a PET (polyethylene terephthalate) film, a PPS (polyphenylene sulfide) film, a PI (polyimide) film, or the like. The thickness of the base member F is not particularly limited, for example, is several $\mu$m to several-tens of $\mu$m. The width or the length of the base member F is also not particularly limited but is adequately determined so as to correspond to the intended use.

An electron beam source EB0 that heats the evaporator (film-formation source) 10 by irradiating it with an electron beam EB is provided in the film formation unit 120.

A shutter (not shown in the drawings) that interrupts the electron beam EB may be provided in the film formation unit 120.

In the film formation unit 120, a shield (shielding member) 20 that has an opening 21 and serves as a film-formation region limiter is provided between the evaporator 10 and the main roller 172. The direction of movement of the base member F in the region near the opening 21 is the X-direction.

Furthermore, a magnet 30 is disposed at the position inside the main roller 172, that is, at the position of the back surface side (the other surface side) of the base member F.

The shield 20 has the opening 21 formed in a rectangular shape which determines a film formation region with respect to the base member F that is wound around the main roller 172. The shield 20 has to need to cover the base member F other than the opening 21.

The shield 20 is a plate-shaped conductor and the electrical potential thereof is a ground potential (grounding state, the shield 20 is grounded). The shield 20 is disposed so as to be substantially parallel to the base member F that is wound around the main roller 172. Note that, the shield 20 may be floating (may have a floating potential) in accordance with conditions for film formation. Also in the case where a predetermined electrical potential is applied to the shield 20 by use of a known power supply, it means that the shield 20 is floating.

The shield 20 is connected to the partition plate (mask) 111 via a shield plate 111b at the outer position of the opening 21 of the main roller 172. The shield plate 111b surrounds the outside of the opening portion 111a provided at the partition plate 111. The shield plate 111b tightly seals between the shield 20 and the partition plate 111. The shield 20 and the shield plate 111b are disposed so as to surround a plasma generation region at the outside thereof.

The length of the opening 21 of the shield 20 in the Z-direction is set to be smaller than the width size of the base member F in the Z-direction.

The magnet 30 is disposed so as to form a magnetic flux directed to the outside of the main roller 172. The magnet 30 is disposed at the inside position of the opening 21 and corresponds to the shape of the plasma generation region.

Moreover, a plasma-generating power supply 124 is connected to the main roller 172 and electric power for generating plasma can be supplied thereto. The plasma-generating power supply 124 is an alternating-current source or a direct-current source. The plasma-generating power supply 124 constitutes a plasma generator.

The deposition apparatus 100 has the above-described configuration.

Note that, not shown in the drawings but the deposition apparatus 100 includes a controller that controls the evaporator 10, the transfer mechanism 170, the vacuum pump PI, the gas supplier S0, the plasma-generating power supply 124, the magnet 30, or the like. The aforementioned controller is configured of a computer including a CPU or a memory and controls the entire operation of the deposition apparatus 100.

Furthermore, the configuration of the deposition apparatus 100 is not limited to the configuration shown in the drawings. For example, the arrangement and the size of the film formation unit 120, the evaporator 10, the transfer unit 130, and the collection unit 160 as well as the evaporator and the types of supply gases, and the electrical potential to be supplied thereto, or the like can be suitably modified. Any of the above-described constituent elements of the deposition apparatus 100 may not be provided.

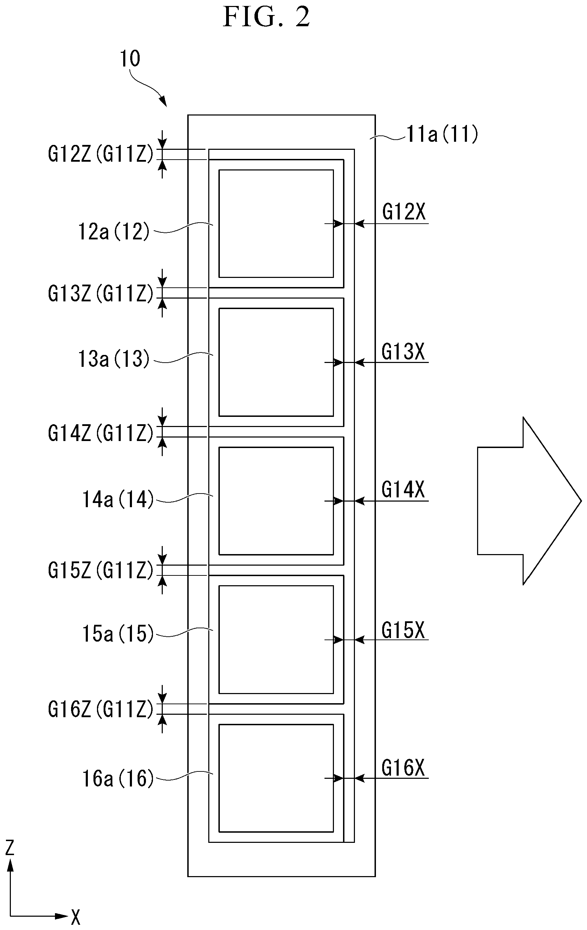

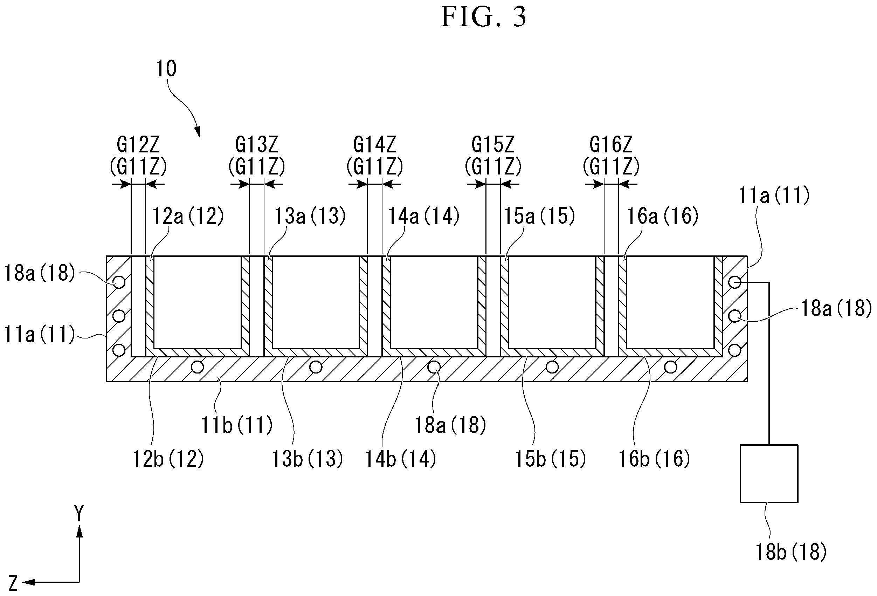

FIG. 2 is a top view showing the evaporator according to the embodiment, and FIG. 3 is a cross-sectional side view showing the evaporator according to the embodiment.

The evaporator 10 is a crucible that evaporates or sublimates a vapor-deposition material.

As shown in FIGS. 2 and 3, the evaporator 10 includes: a hearth liner 11 provided with a cooler 18; and a plurality of liners 12 to 16 that are housed in the hearth liner 11 and accommodate the vapor-deposition materials thereinside.

In the embodiment, although the numbers of the liners 12 to 16 housed in the hearth liner 11 are five, the configurations of the crucibles are not limited to the division number, and the number can be suitably set depending on the condition of codeposition. Particularly, the division number of the crucibles, that is, the number of the liners 12 to 16 to be provided in the hearth liner 11 can be set depending on the width size of the base member F in the Z-direction and the number of vapor-deposition material types used for codeposition.

As shown in FIGS. 2 and 3, the hearth liner 11 is a box formed in a rectangular shape when seen in a plan view.

The hearth liner 11 is disposed in the film formation unit 120 so that the longitudinal direction of the hearth liner 11 extends in the Z-direction orthogonal to the direction of movement of the base member F. The hearth liner 11 is disposed at the position lower than the base member F.

The hearth liner 11 is a base body made of metal, for example, copper (Cu), or the like.

The upper portion of the hearth liner 11 has a rectangular outline and opens. On the entire periphery of the hearth liner 11, a wall portion 11a downwardly extends from the upper opening of the hearth liner 11.

A cooling path 18a that serves as the cooler 18 and circulates a cooling medium is provided in the wall portion 11a and a bottom portion 11b of the hearth liner 11. The cooling path 18a is connected to a cooling source 18b disposed outside the hearth liner 11. The cooling source 18b supplies the cooling medium to the cooling path 18a. The cooling source 18b may be disposed outside the film formation unit 120.

A plurality of the liners 12 to 16 are accommodated in the hearth liner 11.

When seen in a plan view, each of the liners 12 to 16 is a box formed in a rectangular shape smaller than the hearth liner 11. All of the liners 12 to 16 are mounted on the bottom portion 11b of the hearth liner 11.

Each of the liners 12 to 16 has an opening having the same shape at the upper portion thereof. That is, each of the liners 12 to 16 has the same opening space as each other. In addition, each of the liners 12 to 16 may have the opening space different from each other depending on vapor-deposition conditions.

Walls 12a to 16a of the liners 12 to 16 are formed so that the upper edges of the openings of the liners 12 to 16 are on the same plane. Furthermore, the upper edges of the openings of the liners 12 to 16 are formed so as to be on the same plane as the upper edge of the opening of the hearth liner 11 or to be higher than the upper edge of the opening of the hearth liner 11.

The liners 12 to 16 adjacently align in the longitudinal direction of the hearth liner 11. Therefore, the liners 12 to 16 align in the Z-direction orthogonal to the direction of movement of the base member F.

The walls 12a to 16a of the liners 12 to 16 face the wall portion 11a of the hearth liner 11 (surrounding member) or the wall (12a to 16a) of the adjacent liner (surrounding member, 12 to 16). Particularly, the wall 12a of the liner 12 faces the wall portion 11a of the hearth liner 11 (surrounding member) and the wall 13a of the liner 13 (surrounding member) that is adjacent to the liner 12. The wall 13a of the liner 13 faces the wall portion 11a of the hearth liner 11 (surrounding member), the wall 12a of the liner 12 (surrounding member) that is adjacent to the liner 13, and the wall 14a of the liner 14 (surrounding member) that is adjacent to the liner 13. The wall 14a of the liner 14 faces the wall portion 11a of the hearth liner 11 (surrounding member), the wall 13a of the liner 13 (surrounding member) that is adjacent to the liner 14, and the wall 15a of the liner 15 (surrounding member) that is adjacent to the liner 14. The wall 15a of the liner 15 faces the wall portion 11a of the hearth liner 11 (surrounding member), the wall 14a of the liner 14 (surrounding member) that is adjacent to the liner 15, and the wall 16a of the liner 16 (surrounding member) that is adjacent to the liner 15. The wall 16a of the liner 16 faces the wall portion 11a of the hearth liner 11 (surrounding member) and the wall 15a of the liner 15 (surrounding member) that is adjacent to the liner 16. All of the bottom portions 12b to 16b of the liners 12 to 16 are in close contact with the bottom portion 11b of the hearth liner 11.

The liners 12 to 16 is formed of, for example, a metal having a high degree of coefficient of thermal conductivity in order to improve cooling efficiency.

The liners 12 to 16 according to the embodiment are used for codeposition to form a lithium-containing compound film, and the liners accommodate vapor-deposition materials different from each other. In this case, it is preferable that, of the liners 12 to 16, the liners adjacent to each other accommodate vapor-deposition materials different from each other. Moreover, in the case where the number of the liners is an odd number, that is, in the case where the liners 12 to 16 are disposed in the hearth liner 11, the number thereof can be set depending on a vapor pressure and a heating temperature of the vapor-deposition material accommodated in the liner.

The material used to form each of the liners 12 to 16 is a material that does not react with the vapor-deposition material in a heated state when codeposition is carried out. That is, the material used to form each of the liners 12 to 16 is a material that is selected depending on the vapor-deposition material to be accommodated therein and that does not react with the vapor-deposition material in a heated state when codeposition is carried out.

Here, of the liners 12 to 16, a liner accommodating lithium as the vapor-deposition material may be formed of tantalum.

Furthermore, of the liners 12 to 16, a liner accommodating the vapor-deposition material not containing lithium may be formed of copper.

Moreover, of the liners 12 to 16, a liner accommodating the vapor-deposition material containing lithium is formed of tantalum.

Additionally, of the liners 12 to 16, a liner accommodating the vapor-deposition material containing lithium is formed of copper.

Note that, of the liners 12 to 16, in the case where a liner is formed of tantalum, a vapor-deposition material is applicable which has a temperature set in the heated state which is higher than the case where a liner is formed of copper. In other cases, the liners 12 to 16 may be formed of a simple material or an alloy of a metal with a high melting point of 2400°C or higher such as tantalum, tungsten, molybdenum, niobium, or the like.

Particularly, of the liners 12 to 16, in the case where a liner accommodates CoO or $Li_2O$ as a vapor-deposition material, the liner can be formed of Cu. Of the liners 12 to 16, in the case where a liner accommodates Li as a vapor-deposition material, the liner can be formed of Ta.

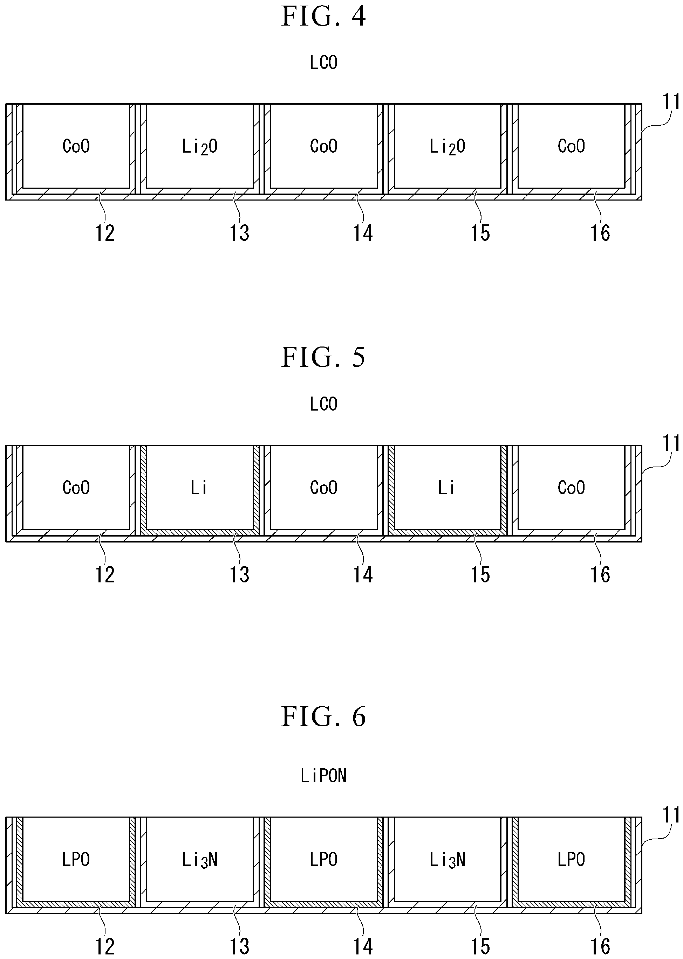

FIG. 4 is an explanatory diagram showing an example of an arrangement of the liners of the evaporator according to the embodiment, and FIG. 5 is an explanatory diagram showing another example of an arrangement of the liners of the evaporator according to the embodiment.

As shown in FIG. 4, in the case where the liners 12 to 16 accommodate CoO and Li as the vapor-deposition material, the alignment can be adopted in which the liners 12, 14, and 16 accommodate CoO and the liners 13 and 15 accommodate Li. At this time, the liners 12, 14, and 16 can be formed of Cu, and the liners 13 and 15 can be formed of Ta.

As shown in FIG. 5, in the case where the liners 12 to 16 accommodate CoO and $Li_2O$ as the vapor-deposition material, the alignment can be adopted in which the liners 12, 14, and 16 accommodate CoO and the liners 13 and 15 accommodate $Li_2O$. At this time, the liners 12 to 16 can be formed of Cu.

In the X-direction that is the direction of movement of the base member F, each of the sizes of the liners 12 to 16 is set to be smaller the width size of the hearth liner 11. Additionally, in the Z-direction that is orthogonal to the direction of movement of the base member F, the total of the sizes of the liners 12 to 16 is set to be smaller than the longitudinal size of the hearth liner 11.

In the evaporator 10, in the configuration in which the liners 12 to 16 are disposed inside the hearth liner 11, the walls 12a to 16a of the liners 12 to 16 come into contact with the surrounding member in a heated state, in contrast, a gap occurs between the wall and the surrounding member in a non-heated state.

The liner 12 has a wall portion 12a extending in the Z-direction thereof, and the hearth liner 11 has a gap G12X in the X-direction between the wall portion 11a and the wall portion 12a facing the wall portion 11a. The gap G12X is determined so as to correspond to thermal expansion at a heating temperature when codeposition is carried out. Specifically, the gap G12X is determined so as to correspond to a coefficient of thermal expansion of the material of the liner 12. The gap G12X is determined so as to correspond to the size of the liner 12 in the X-direction and the thermally-expanded size in the X-direction which corresponds to the material of the liner 12. That is, the gap G12X is determined such that the wall portion 12a of the thermally-expanded liner 12 is brought into close contact with the wall portion 11a of the hearth liner 11 at the heating temperature when codeposition is carried out.

Note that, as shown in FIG. 2, the hearth liner 11 has two wall portions 11a which are located at the right side and the left side, and the liner 12 is disposed between the two wall portions 11a. Here, in the non-heated state, there is a size difference between the outer size of the liner 12 and the distance at which the two wall portions 11a are separated from each other. This difference is the gap. For example, in the non-heated state, the gap may occur between the right side wall portion 11a and the wall portion 12a facing the right side wall portion 11a, and the gap may occur between the left side wall portion 11a and the wall portion 12a facing the left side wall portion 11a. In order to explain the gap, FIG. 2 schematically shows the case where the gap G12X occurs between the right side wall portion 11a and the wall portion 12a of the liner 12 in the non-heated state. In other words, the gap G12X shown in FIG. 2 is a sum of the gap that occurs at the right side wall portion 11a and the gap that occurs at the left side wall portion 11a. Additionally, regarding the difference between the case of the non-heated state and the case of the heated state in gap in the X-direction, the gap G12X represents the difference between the gap in the non-heated state (the size difference in the non-heated state between the outer size of the liner 12 and the distance at which the two wall portions 11a are separated from each other) and the gap in the heated state (the size difference in the heated state between the outer size of the liner 12 and the distance at which the two wall portions 11a are separated from each other). Note that, explanations for gaps G13X, G14X, G15X, and G16X regarding the wall portions 13a, 14a, 15a, and 16a are the same as that of the gap G12X described above.

Similarly, the liner 13 has a wall portion 13a extending in the Z-direction thereof, and the hearth liner 11 has a gap G13X in the X-direction between the wall portion 11a and the wall portion 13a facing the wall portion 11a. The gap G13X is determined so as to correspond to thermal expansion at a heating temperature when codeposition is carried out. Specifically, the gap G13X is determined so as to correspond to a coefficient of thermal expansion of the material of the liner 13. The gap G13X is determined so as to correspond to the size of the liner 13 in the X-direction and the thermally-expanded size in the X-direction which corresponds to the material of the liner 13. That is, the gap G13X is determined such that the wall portion 13a of the thermally-expanded liner 13 is brought into close contact with the wall portion 11a of the hearth liner 11 at the heating temperature when codeposition is carried out.

Similarly, the liner 14 has a wall portion 14a extending in the Z-direction thereof, and the hearth liner 11 has a gap G14X in the X-direction between the wall portion 11a and the wall portion 14a facing the wall portion 11a. The gap G14X is determined so as to correspond to thermal expansion at a heating temperature when codeposition is carried out. Specifically, the gap G14X is determined so as to correspond to a coefficient of thermal expansion of the material of the liner 14. The gap G14X is determined so as to correspond to the size of the liner 14 in the X-direction and the thermally-expanded size in the X-direction which corresponds to the material of the liner 14. That is, the gap G14X is determined such that the wall portion 14a of the thermally-expanded liner 14 is brought into close contact with the wall portion 11a of the hearth liner 11 at the heating temperature when codeposition is carried out.

Similarly, the liner 15 has a wall portion 15a extending in the Z-direction thereof, and the hearth liner 11 has a gap G15X in the X-direction between the wall portion 11a and the wall portion 15a facing the wall portion 11a. The gap G15X is determined so as to correspond to a coefficient of thermal expansion of the material of the liner 15. Particularly, the gap G15X is determined so as to correspond to thermal expansion at a heating temperature when codeposition is carried out. The gap G15X is determined so as to correspond to the size of the liner 15 in the X-direction and the thermally-expanded size in the X-direction which corresponds to the material of the liner 15. That is, the gap G15X is determined such that the wall portion 15a of the thermally-expanded liner 15 is brought into close contact with the wall portion 11a of the hearth liner 11 at the heating temperature when codeposition is carried out.

Similarly, the liner 16 has a wall portion 16a extending in the Z-direction thereof, and the hearth liner 11 has a gap G16X in the X-direction between the wall portion 11a and the wall portion 16a facing the wall portion 11a. The gap G16X is determined so as to correspond to a coefficient of thermal expansion of the material of the liner 16. Particularly, the gap G16X is determined so as to correspond to thermal expansion at a heating temperature when codeposition is carried out. The gap G16X is determined so as to correspond to the size of the liner 16 in the X-direction and the thermally-expanded size in the X-direction which corresponds to the material of the liner 16. That is, the gap G16X is determined such that the wall portion 16a of the thermally-expanded liner 16 is brought into close contact with the wall portion 11a of the hearth liner 11 at the heating temperature when codeposition is carried out.

Similarly, between the two wall portions 11a (the wall portions 11a orthogonal to the right side wall portion 11a and the left side wall portion 11a described above) of the hearth liner 11 which face each other in the Z-direction, the liners 12 to 16 align so as to have gaps G12Z, G13Z, G14Z, G15Z, and G16Z in the Z-direction. As described below, the sum of sizes of the gaps G12Z, G13Z, G14Z, G15Z, and G16Z is represented as G11Z, and each of the gaps G12Z, G13Z, G14Z, G15Z, and G16Z is part of the gap G11Z.

Specifically, in the Z-direction, there is the gap G12Z between the wall portion 11a of the hearth liner 11 and the wall portion 12a of the liner 12, there is the gap G13Z between the wall portion 12a of the liner 12 and the wall portion 13a of the liner 13, there is the gap G14Z between the wall portion 13a of the liner 13 and the wall portion 14a of the liner 14, there is the gap G15Z between the wall portion 14a of the liner 14 and the wall portion 15a of the liner 15, and there is the gap G16Z between the wall portion 15a of the liner 15 and the wall portion 16a of the liner 16.

The gap G11Z is determined so as to correspond to thermal expansion at a heating temperature when codeposition is carried out. Particularly, the gap G11Z is determined so as to correspond to the sum of the sizes of the liners 12 to 16 in the Z-direction and a coefficient of thermal expansion of the material of each of the liners 12 to 16. That is, the gap G11Z is determined such that, at the heating temperature when codeposition is carried out, the wall portions 12a and 16a located at the both end portions of the thermally-expanded liners 12 to 16 in the Z-direction are brought into close contact with the wall portions 11a of the hearth liner 11 which face the wall portions 12a and 16a, and such that two liners adjacent to each other of the thermally-expanded liners 12 to 16 are brought into close contact with each other in the Z-direction.

As mentioned above, the gap G11Z is determined so as to correspond to a coefficient of thermal expansion of the material of each of the liners 12 to 16. That is, the gap G11Z is determined by the sum of: the gap G12Z that corresponds to the size of the liner 12 in the Z-direction and the coefficient of thermal expansion of the material of the liner 12; the gap G13Z that corresponds to the size of the liner 13 in the Z-direction and the coefficient of thermal expansion of the material of the liner 13; the gap G14Z that corresponds to the size of the liner 14 in the Z-direction and the coefficient of thermal expansion of the material of the liner 14; the gap G15Z that corresponds to the size of the liner 15 in the Z-direction and the coefficient of thermal expansion of the material of the liner 15; and the gap G16Z that corresponds to the size of the liner 16 in the Z-direction and the coefficient of thermal expansion of the material of the liner 16.

Particularly, in the Z-direction, the liners 12 to 16 and the hearth liner 11 have the following dimensional relationship.

$$G11Z = G12Z + G13Z + G14Z + G15Z + G16Z$$

The above gaps G12X to G16X and G11Z to G16Z are determined by the materials of the liners 12 to 16. Accordingly, in the case where the materials of the liners 12 to 16 vary, the values of the gaps G12X to G16X and G11Z to G16Z are also changed depending thereon.

Here, each of the gaps G12X to G16X and G11Z to G16Z of the liners 12 to 16 is determined as a ratio of the thermally-expanded size when heating is carried out so that a temperature becomes 500°C from a room temperature to the size of each of the liners 12 to 16.

In the following explanation, a ratio of the gap G12X to the size of the liner 12 is reffered to as RX12, a ratio of the gap G13X to the size of the liner 13 is reffered to as RX13, a ratio of the gap G14X to the size of the liner 14 is reffered to as RX14, a ratio of the gap G15X to the size of the liner 15 is reffered to as RX15, and a ratio of the gap G16X to the size of the liner 16 is reffered to as RX16.

Specifically, in the X-direction, in the case where the liners 12 to 16 are formed of Cu, each of the ratios RX12, RX13, RX14, RX15, and RX16 is determined so as to be in the range of 0.0007 to 0.00839. Moreover, in the case where the liners 12 to 16 are formed of Ta, each of the ratios RX12, RX13, RX14, RX15, and RX16 is determined so as to be in the range of 0.0007 to 0.0032.

Each of the ratios RX12, RX13, RX14, RX15, and RX16 may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RX12, RX13, RX14, RX15, and RX16 be in the above-mentioned range. Additionally, in the case where each of the ratios RX12, RX13, RX14, RX15, and RX16 is larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

Furthermore, the width of the outer shape of each of the liners 12 to 16 in the X-direction can be in a range of 40 mm to 150 mm and the length of the outer shape of each of the liners 12 to 16 in the Z-direction can be in a range of 40 mm to 150 mm.

Here, for example, in the case where the liners 12 to 16 are formed of Cu, the gaps G12X to G16X can be determined so as to be in the range of 0.05 mm to 0.60 mm. Additionally, in the case where the liners 12 to 16 are formed of Ta, the gaps G12X to G16X can be determined so as to be in the range of 0.05 mm to 0.23 mm.

The gaps G12X to G16X may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RX12, RX13, RX14, RX15, and RX16 be in the above-mentioned range. Moreover, in the case where the gaps G12X to G16X are larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

Next, the gap G11Z in the case where the materials of two of the liners 12 to 16 are different each other will be explained. Firstly, in the case where one liner is formed of Cu, a ratio of the gap to the size of the Cu-liner in the Z-direction is determined so as to be in the range of 0.0007 to 0.00839. In addition, in the case where one liner is formed of Ta, a ratio of the gap to the size of the Ta-liner in the Z-direction is determined so as to be in the range of 0.0007 to 0.0032.

Here, the gap G11Z (the sum of G12Z, G13Z, G14Z, G15Z, and G16Z) in the hearth liner 11 is determined by the numbers of the Cu-liner and the Ta-liner accommodated in the hearth liner 11 and the above-described gap ratios. Specifically, the value of the gap is obtained by multiplying the numbers of the Cu-liner by the above-described gap ratio (0.0007 to 0.00839). Similarly, the value of the gap is obtained by multiplying the numbers of the Ta-liner by the above-described gap ratio (0.0007 to 0.0032). The gap G11Z is the value determined by adding the above obtained values.

In the following explanation, a ratio of the gap G12Z to the size of the liner 12 is reffered to as RZ12, a ratio of the gap G13Z to the size of the liner 13 is reffered to as RZ13, a ratio of the gap G14Z to the size of the liner 14 is reffered to as RZ14, a ratio of the gap G15Z to the size of the liner 15 is reffered to as RZ15, and a ratio of the gap G16Z to the size of the liner 16 is reffered to as RZ16.

In the Z-direction in which the liners 12 to 16 align, each of the ratios RZ12, RZ13, RZ14, RZ15, and RZ16 may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RZ12, RZ13, RZ14, RZ15, and RZ16 be in the above-mentioned range. Similarly, in the case where each of the ratios RZ12, RZ13, RZ14, RZ15, and RZ16 is larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

In the evaporator 10 according to the embodiment, as shown in FIG. 4, in the case where the five liners 12 to 16 formed of copper are adjacently disposed inside the hearth liner 11 in the Z-direction, it is preferable that the gaps G12X to G16X and G11Z to G16Z in the non-heated state be determined as follows.

Specifically, in the example shown in FIG. 4, the following configuration is determined so as to correspond to the constituent material of Cu.

A ratio of the gap G12X to the width of the outer shape in the X-direction of the liner 12 formed of Cu is determined so as to be in the range of 0.0007 to 0.00839. The gap G12X is determined so as to be in the range of 0.05 mm to 0.60 mm.

A ratio of the gap G13X to the width of the outer shape in the X-direction of the liner 13 formed of Cu is determined so as to be in the range of 0.0007 to 0.00839. The gap G13X is determined so as to be in the range of 0.05 mm to 0.60 mm.

A ratio of the gap G14X to the width of the outer shape in the X-direction of the liner 14 formed of Cu is determined so as to be in the range of 0.0007 to 0.00839. The gap G14X is determined so as to be in the range of 0.05 mm to 0.50 mm.

A ratio of the gap G15X to the width of the outer shape in the X-direction of the liner 15 formed of Cu is determined so as to be in the range of 0.0007 to 0.00839. The gap G15X is determined so as to be in the range of 0.05 mm to 0.60 mm.

A ratio of the gap G16X to the width of the outer shape in the X-direction of the liner 16 formed of Cu is determined so as to be in the range of 0.0007 to 0.00839. The gap G16X is determined so as to be in the range of 0.05 mm to 0.60 mm.

A ratio of the gap G11Z to the sum of the lengths of the outer shapes in the Z-direction of the liners 12 to 16 formed of Cu is determined so as to be in the range of 0.0035 to 0.042. The gap G11Z is determined so as to be in the range of 0.25 mm to 3.0 mm.

A ratio of the gap G12Z to the length of the outer shape in the Z-direction of the liner 12 formed of Cu is determined so as to be in the range of 0.0007 to 0.00839. The gap G12Z is determined so as to be in the range of 0.05 mm to 0.60 mm.

A ratio of the gap G13Z to the length of the outer shape in the Z-direction of the liner 13 formed of Cu is determined so as to be in the range of 0.0007 to 0.00839. The gap G13Z is determined so as to be in the range of 0.05 mm to 0.60 mm.

A ratio of the gap G14Z to the length of the outer shape in the Z-direction of the liner 14 formed of Cu is determined so as to be in the range of 0.0007 to 0.00839. The gap G14Z is determined so as to be in the range of 0.05 mm to 0.60 mm.

A ratio of the gap G15Z to the length of the outer shape in the Z-direction of the liner 15 formed of Cu is determined so as to be in the range of 0.0007 to 0.00839. The gap G15Z is determined so as to be in the range of 0.05 mm to 0.60 mm.

A ratio of the gap G16Z to the length of the outer shape in the Z-direction of the liner 16 formed of Cu is determined so as to be in the range of 0.0007 to 0.00839. The gap G16Z is determined so as to be in the range of 0.05 mm to 0.60 mm.

In the evaporator 10 according to the embodiment, as shown in FIG. 5, in the case where the three liners 12, 14, and 16 formed of copper and the two liners 13 and 15 formed of tantalum are adjacently disposed inside the hearth liner 11 in the Z-direction, it is preferable that the gaps G12X to G16X and G11Z to G16Z in the non-heated state be determined as follows.

Specifically, in the example shown in FIG. 5, the following configuration is determined so as to correspond to the constituent materials of Cu and Ta.

A ratio of the gap G12X to the width of the outer shape in the X-direction of the liner 12 formed of Cu is determined so as to be in the range of 0.0007 to 0.00839. The gap G12X is determined so as to be in the range of 0.05 mm to 0.60 mm.

A ratio of the gap G13X to the width of the outer shape in the X-direction of the liner 13 formed of Ta is determined so as to be in the range of 0.0007 to 0.0032. The gap G13X is determined so as to be in the range of 0.05 mm to 0.23 mm.

A ratio of the gap G14X to the width of the outer shape in the X-direction of the liner 14 formed of Cu is determined so as to be in the range of 0.0007 to 0.00839. The gap G14X is determined so as to be in the range of 0.05 mm to 0.60 mm.

A ratio of the gap G15X to the width of the outer shape in the X-direction of the liner 15 formed of Ta is determined so as to be in the range of 0.0007 to 0.0032. The gap G15X is determined so as to be in the range of 0.05 mm to 0.23 mm.

A ratio of the gap G16X to the width of the outer shape in the X-direction of the liner 16 formed of Cu is determined so as to be in the range of 0.0007 to 0.00839. The gap G16X is determined so as to be in the range of 0.05 mm to 0.60 mm.

A ratio of the gap G11Z to the sum of the lengths of the outer shapes in the Z-direction of the liners 12 to 16 is determined so as to be in the range of 0.0035 to 0.0316 so as to correspond to the above-described ratios regarding Cu and Ta. The gap G11Z is determined so as to be in the range of 0.25 mm to 2.26 mm.

A ratio of the gap G12Z to the length of the outer shape in the Z-direction of the liner 12 formed of Cu is determined so as to be in the range of 0.0007 to 0.00839. The gap G12Z is determined so as to be in the range of 0.05 mm to 0.60 mm.

A ratio of the gap G13Z to the length of the outer shape in the Z-direction of the liner 13 formed of Ta is determined so as to be in the range of 0.0007 to 0.0032. The gap G13Z is determined so as to be in the range of 0.05 mm to 0.23 mm.

A ratio of the gap G14Z to the length of the outer shape in the Z-direction of the liner 14 formed of Cu is determined so as to be in the range of 0.0007 to 0.00839. The gap G14Z is determined so as to be in the range of 0.05 mm to 0.60 mm.

A ratio of the gap G15Z to the length of the outer shape in the Z-direction of the liner 15 formed of Ta is determined so as to be in the range of 0.0007 to 0.0032. The gap G15Z is determined so as to be in the range of 0.05 mm to 0.23 mm.

A ratio of the gap G16Z to the length of the outer shape in the Z-direction of the liner 16 formed of Cu is determined so as to be in the range of 0.0007 to 0.00839. The gap G16Z is determined so as to be in the range of 0.05 mm to 0.60 mm.

A method of forming a film in the deposition apparatus 100 according to the embodiment will be described.

Particularly, as the following film formation method, a method of forming a compound film that serves as a thin film and contains oxygen and lithium on a web-shaped base member F will be described. Specifically, a method of forming a compound film formed of LCO (cobalt acid lithium) will be described.

LCO (cobalt acid lithium) is appropriate for a boundary face of a positive electrode of batteries or secondary batteries. Therefore, as a typical layer system to be used, an LCO layer having a layer thickness of approximately several $\mu$m can be formed.

Deposition of an LCO layer using an electron-beam coating method is possible. In this case, $Li_2O$ (lithium oxide) and CoO (cobalt oxide) shown in FIG. 4 or lithium (Li) and CoO (cobalt oxide) shown in FIG. 5 are evaporated in the atmosphere having oxygen-containing reactant gas by an electron beam that directly acts on an evaporation material.

In the liners 12 to 16, CoO and Li which serve as the vapor-deposition materials including at least lithium element are alternately accommodated as shown in FIG. 5. Particularly, the liners 12, 14, and 16 accommodate CoO and the liners 13 and 15 accommodate Li. The vapor-deposition materials are evaporated in a thermal evaporation apparatus inside a vacuum chamber, and therefore the LCO layer is deposited on the substrate.

At this time, all of the liners 12 to 16 which are before subjected to heating are placed inside the hearth liner 11 in the X-direction so as to be separated from the wall portion 11a of the hearth liner 11 at a half value of each of the gaps G12X to G16X. Moreover, the liners 12 to 16 which are before subjected to heating are arranged in the Z-direction so as to be separated from each other at the distance obtained by equally dividing the sum of the gap G12Z to G16Z (equally dividing the sum into five gaps). That is, each of the liners 12 to 16 which are before subjected to heating are positioned so as to be separated from the surrounding member at the distance corresponding to thermal expansion when heating is carried out.

Note that, in FIGS. 2 and 3, in order to explain the gaps G12X to G16Z, the liners 12 to 16 are in contact with the inside wall surface of the hearth liner 11; however, each of the liners 12 to 16 is arranged so as to be separated from the surrounding member at an equal distance in the X-direction and the Z-direction, and thereafter the liners are heated. At this time, when heating is carried out by scanning the electron beam EB, it is preferable to heat the liners 12 to 16 in a state where an equal distance is maintained.

Next, the vapor-deposition materials are evaporated by directly irradiating the materials with the electron beam EB emitted from an electron gun EB0. At the same time, a component containing oxygen, preferably, an oxygen-containing reactant gas is introduced into the vacuum chamber, and plasma penetrates through the evaporated particle cloud rising up therein.

As an oxygen-containing reactant gas, for example, a gas such as oxygen ($O_2$) is suitable. With respect to the introduction of oxygen-containing reactant gas, for example, a precursor (precursors) containing oxygen may also be introduced into the vacuum chamber.

Regarding the film formation in the deposition apparatus 100, firstly, the inside of the vacuum chamber 110 is vacuumed, and the film formation unit 120, the transfer unit 130, and the collection unit 160 are maintained in a predetermined degree of vacuum.

Additionally, the transfer mechanism 170 supporting the base member F is driven, and the base member F is fed from the unwinding roller 171 to the rewinding roller 173. In the film formation unit 120, the base member F is fed (moved) in the X-direction.

Note that, a power collector, or the like is formed on a predetermined region of the base member F in advance.

In the film formation unit 120, oxygen-containing gas is introduced into the inside of the film formation unit 120 from the gas supplier S0.

Additionally, in the film formation unit 120, electric power for generating plasma is supplied to the main roller 172 from the plasma-generating power supply 124 connected thereto. At the same time, in the film formation unit 120, due to the electric power supplied from the power supply connected thereto, the magnet 30 generates a magnetic flux.

Consequently, plasma is generated in the plasma generation region near the opening 21.

In the film formation unit 120, the evaporator 10 is heated up by the ion beam EB, the vapor-deposition material containing the vapor-deposition material containing lithium and cobalt evaporate from the liners 12 to 16, and a vaporization flow of the vapor-deposition material containing lithium and cobalt (vapor-deposition material) that is emitted toward the base member F on the main roller 172 is generated.

At this time, a heating condition of the vapor-deposition material accommodated in each of the liners 12 to 16 is determined depending on a vapor pressure, a sublimation temperature, an amount of evaporation, the ratio necessary for codeposition, input power necessary for codeposition, or the like of each vapor-deposition material.

Furthermore, the region of the base member F to which the vaporization flow of the vapor-deposition material containing lithium and cobalt (vapor-deposition material) reaches is regulated by the opening 21 of the shield 20.

At the region near the opening 21 of the shield 20, the vapor-deposition particles containing lithium and cobalt activated by the oxygen gas that was converted into plasma are formed on the top surface of the base member F, and a compound film containing oxygen is thereby formed thereon.

In the heated state of codeposition, a temperature of each of the liners 12 to 16 increases. In accordance with this, the liners 12 to 16 are thermally expanded so as to correspond to coefficients of thermal expansion the respective materials. As a result, each of the walls 12a to 16a of the liners 12 to 16 comes into contact with the wall portion 11a of the hearth liner 11 or the walls 12a to 16a in a state where they face each other.

That is, each of the liners 12 to 16 is thermally-expanded so that each of the gaps G12X to G16Z becomes zero inside the hearth liner 11.

Each of the walls 12a to 16a of the liners 12 to 16 is brought into close contact with the surrounding member which is adjacent and opposed to the walls.

At this time, each of the liners 12 to 16 comes into contact with the hearth liner 11 cooled by the cooler 18 and is thereby cooled down due to heat transfer from the walls 12a to 16a to the wall portion 11a and the bottom portion 11b. Additionally, each of the liners 12 to 16 is cooled down by heat transfer from the adjacent walls 12a to 16a of the liners 12 to 16.

Accordingly, the temperature of each of the liners 12 to 16 is maintained to be in a temperature range not to chemically react with the vapor-deposition material thereinside. At the same time, the vapor-deposition material located at the center of the opening of each of the liners 12 to 16 is molten, evaporates or sublimates. The vapor-deposition material located close to the peripheral edge of the opening of the wall portion 12a to 16a is not molten or a state where the temperature thereof gradually increases is maintained.

Accordingly, the deposition apparatus 100 according to the embodiment, codeposition can be carried out without generation of contamination, change of a compositional ratio, or the like.

Consequently, in the deposition apparatus 100 according to the embodiment, it is possible to set the film composition of the compound film to be in a preferable range by the liners 12 to 16 in which the vapor-deposition materials different from each other are alternately disposed, and it is possible to manufacture the compound film having improved film characteristics.

In addition, the case where the deposition apparatus 100 according to the embodiment is a roll-to-roll apparatus is explained; however, the invention is not limited to the configuration thereof, and a configuration may be adopted which forms a film on a single-wafer substrate in the middle of transferring the substrate. Furthermore, the deposition apparatus according to the embodiment may be provided with not only the film formation unit of the lithium compound film but also another film formation unit or another processing unit.

Hereinafter, a deposition apparatus according to a second embodiment of the invention will be described with reference to drawings.

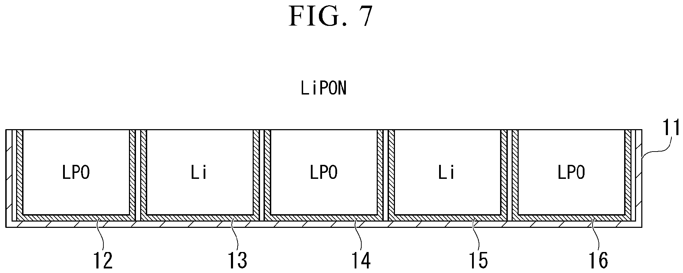

FIG. 6 is an explanatory diagram showing an example of an arrangement of the liners of the evaporator according to the embodiment, and FIG. 7 is an explanatory diagram showing another example of an arrangement of the liners of the evaporator according to the embodiment. The embodiment is different from the aforementioned first embodiment in formation of a compound film formed of LiPON, and otherwise, identical reference numerals are used for the elements which correspond to those of the above-described first embodiment, and the explanations thereof are omitted or simplified here.

In the embodiment, in the case where at least one of the liners 12 to 16 accommodates $Li_3N$ as the vapor-deposition material used for forming LiPON, the liner can be formed of Cu. Moreover, in the case where at least one of the liners 12 to 16 accommodates LPO or Li as the vapor-deposition material used for forming LiPON, the liner can be formed of Ta.

As shown in FIG. 6, in the case where the liners 12 to 16 accommodate LPO and $Li_3N$ as the vapor-deposition material, the alignment can be adopted in which the liners 12, 14, and 16 accommodate LPO and the liners 13 and 15 accommodate $Li_3N$. At this time, the liners 12, 14, and 16 can be formed of Ta, and the liners 13 and 15 can be formed of Cu.

As shown in FIG. 7, in the case where the liners 12 to 16 accommodate LPO and Li as the vapor-deposition material, the alignment can be adopted in which the liners 12, 14, and 16 accommodate LPO and the liners 13 and 15 accommodates Li. At this time, the liners 12 to 16 can be formed of Ta.

In the X-direction that is the direction of movement of the base member F, each of the sizes of the liners 12 to 16 is set to be smaller the width size of the hearth liner 11. Additionally, in the Z-direction that is orthogonal to the direction of movement of the base member F, the total of the sizes of the liners 12 to 16 is set to be smaller than the longitudinal size of the hearth liner 11.

In the evaporator 10, in the configuration in which the liners 12 to 16 are disposed inside the hearth liner 11, the walls 12a to 16a of the liners 12 to 16 come into contact with the surrounding member in a heated state, in contrast, a gap occurs between the wall and the surrounding member in a non-heated state.

The liner 12 has a wall portion 12a extending in the Z-direction thereof, and the hearth liner 11 has a gap G12X in the X-direction between the wall portion 11a and the wall portion 12a facing the wall portion 11a. The gap G12X is determined so as to correspond to thermal expansion at a heating temperature when codeposition is carried out. Specifically, the gap G12X is determined so as to correspond to a coefficient of thermal expansion of the material of the liner 12. The gap G12X is determined so as to correspond to the size of the liner 12 in the X-direction and the thermally-expanded size in the X-direction which corresponds to the material of the liner 12. That is, the gap G12X is determined such that the wall portion 12a of the thermally-expanded liner 12 is brought into close contact with the wall portion 11a of the hearth liner 11 at the heating temperature when codeposition is carried out.

Regarding the difference between the case of the non-heated state and the case of the heated state in gap in the X-direction, the gap G12X represents the difference between the gap in the non-heated state (the size difference in the non-heated state between the outer size of the liner 12 and the distance at which the two wall portions 11a are separated from each other) and the gap in the heated state (the size difference in the heated state between the outer size of the liner 12 and the distance at which the two wall portions 11a are separated from each other).

Similarly, the liner 13 has a wall portion 13a extending in the Z-direction thereof, and the hearth liner 11 has a gap G13X in the X-direction between the wall portion 11a and the wall portion 13a facing the wall portion 11a. The gap G13X is determined so as to correspond to thermal expansion at a heating temperature when codeposition is carried out. Specifically, the gap G13X is determined so as to correspond to a coefficient of thermal expansion of the material of the liner 13. The gap G13X is determined so as to correspond to the size of the liner 13 in the X-direction and the thermally-expanded size in the X-direction which corresponds to the material of the liner 13. That is, the gap G13X is determined such that the wall portion 13a of the thermally-expanded liner 13 is brought into close contact with the wall portion 11a of the hearth liner 11 at the heating temperature when codeposition is carried out.

Similarly, the liner 14 has a wall portion 14a extending in the Z-direction thereof, and the hearth liner 11 has a gap G14X in the X-direction between the wall portion 11a and the wall portion 14a facing the wall portion 11a. The gap G14X is determined so as to correspond to thermal expansion at a heating temperature when codeposition is carried out. Specifically, the gap G14X is determined so as to correspond to a coefficient of thermal expansion of the material of the liner 14. The gap G14X is determined so as to correspond to the size of the liner 14 in the X-direction and the thermally-expanded size in the X-direction which corresponds to the material of the liner 14. That is, the gap G14X is determined such that the wall portion 14a of the thermally-expanded liner 14 is brought into close contact with the wall portion 11a of the hearth liner 11 at the heating temperature when codeposition is carried out.

Similarly, the liner 15 has a wall portion 15a extending in the Z-direction thereof, and the hearth liner 11 has a gap G15X in the X-direction between the wall portion 11a and the wall portion 15a facing the wall portion 11a. The gap G15X is determined so as to correspond to a coefficient of thermal expansion of the material of the liner 15. Particularly, the gap G15X is determined so as to correspond to thermal expansion at a heating temperature when codeposition is carried out. The gap G15X is determined so as to correspond to the size of the liner 15 in the X-direction and the thermally-expanded size in the X-direction which corresponds to the material of the liner 15. That is, the gap G15X is determined such that the wall portion 15a of the thermally-expanded liner 15 is brought into close contact with the wall portion 11a of the hearth liner 11 at the heating temperature when codeposition is carried out.

Similarly, the liner 16 has a wall portion 16a extending in the Z-direction thereof, and the hearth liner 11 has a gap G16X in the X-direction between the wall portion 11a and the wall portion 16a facing the wall portion 11a. The gap G16X is determined so as to correspond to a coefficient of thermal expansion of the material of the liner 16. Particularly, the gap G16X is determined so as to correspond to thermal expansion at a heating temperature when codeposition is carried out. The gap G16X is determined so as to correspond to the size of the liner 16 in the X-direction and the thermally-expanded size in the X-direction which corresponds to the material of the liner 16. That is, the gap G16X is determined such that the wall portion 16a of the thermally-expanded liner 16 is brought into close contact with the wall portion 11a of the hearth liner 11 at the heating temperature when codeposition is carried out.

Similarly, between the two wall portions 11a (the wall portions 11a orthogonal to the right side wall portion 11a and the left side wall portion 11a described above) of the hearth liner 11 which face each other in the Z-direction, the liners 12 to 16 align so as to have gaps G12Z, G13Z, G14Z, G15Z, and G16Z in the Z-direction. As described below, the sum of sizes of the gaps G12Z, G13Z, G14Z, G15Z, and G16Z is represented as G11Z, and each of the gaps G12Z, G13Z, G14Z, G15Z, and G16Z is part of the gap G11Z.

Specifically, in the Z-direction, there is the gap G12Z between the wall portion 11a of the hearth liner 11 and the wall portion 12a of the liner 12, there is the gap G13Z between the wall portion 12a of the liner 12 and the wall portion 13a of the liner 13, there is the gap G14Z between the wall portion 13a of the liner 13 and the wall portion 14a of the liner 14, there is the gap G15Z between the wall portion 14a of the liner 14 and the wall portion 15a of the liner 15, and there is the gap G16Z between the wall portion 15a of the liner 15 and the wall portion 16a of the liner 16.

The gap G11Z is determined so as to correspond to thermal expansion at a heating temperature when codeposition is carried out. Particularly, the gap G11Z is determined so as to correspond to the sum of the sizes of the liners 12 to 16 in the Z-direction and a coefficient of thermal expansion of the material of each of the liners 12 to 16. That is, the gap G11Z is determined such that, at the heating temperature when codeposition is carried out, the wall portions 12a and 16a located at the both end portions of the thermally-expanded liners 12 to 16 in the Z-direction are brought into close contact with the wall portions 11a of the hearth liner 11 which face the wall portions 12a and 16a, and such that two liners adjacent to each other of the thermally-expanded liners 12 to 16 are brought into close contact with each other in the Z-direction.

As mentioned above, the gap G11Z is determined so as to correspond to a coefficient of thermal expansion of the material of each of the liners 12 to 16. That is, the gap G11Z is determined by the sum of: the gap G12Z that corresponds to the size of the liner 12 in the Z-direction and the coefficient of thermal expansion of the material of the liner 12; the gap G13Z that corresponds to the size of the liner 13 in the Z-direction and the coefficient of thermal expansion of the material of the liner 13; the gap G14Z that corresponds to the size of the liner 14 in the Z-direction and the coefficient of thermal expansion of the material of the liner 14; the gap G15Z that corresponds to the size of the liner 15 in the Z-direction and the coefficient of thermal expansion of the material of the liner 15; and the gap G16Z that corresponds to the size of the liner 16 in the Z-direction and the coefficient of thermal expansion of the material of the liner 16.

Particularly, in the Z-direction, the liners 12 to 16 and the hearth liner 11 have the following dimensional relationship.

$$G11Z = G12Z + G13Z + G14Z + G15Z + G16Z$$

The above gaps G12X to G16X and G11Z to G16Z are determined by the materials of the liners 12 to 16. Accordingly, in the case where the materials of the liners 12 to 16 vary, the values of the gaps G12X to G16X and G11Z to G16Z are also changed depending thereon.

Here, each of the gaps G12X to G16X and G11Z to G16Z of the liners 12 to 16 is determined as a ratio of the thermally-expanded size when heating is carried out so that a temperature becomes 500°C from a room temperature to the size of each of the liners 12 to 16.

Specifically, in the X-direction, in the case where the liners 12 to 16 are formed of Cu, each of the ratios RX12, RX13, RX14, RX15, and RX16 is determined so as to be in the range of 0.0007 to 0.00839. Moreover, in the case where the liners 12 to 16 are formed of Ta, each of the ratios RX12, RX13, RX14, RX15, and RX16 is determined so as to be in the range of 0.0007 to 0.0032.

Each of the ratios RX12, RX13, RX14, RX15, and RX16 may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RX12, RX13, RX14, RX15, and RX16 be in the above-mentioned range. Additionally, in the case where each of the ratios RX12, RX13, RX14, RX15, and RX16 is larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

Furthermore, the width of the outer shape of each of the liners 12 to 16 in the X-direction can be in a range of 40 mm to 150 mm and the length of the outer shape of each of the liners 12 to 16 in the Z-direction can be in a range of 40 mm to 150 mm.

Here, for example, in the case where the liners 12 to 16 are formed of Cu, the gaps G12X to G16X can be determined so as to be in the range of 0.05 mm to 0.60 mm. Additionally, in the case where the liners 12 to 16 are formed of Ta, the gaps G12X to G16X can be determined so as to be in the range of 0.05 mm to 0.23 mm.

The gaps G12X to G16X may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RX12, RX13, RX14, RX15, and RX16 be in the above-mentioned range. Moreover, in the case where the gaps G12X to G16X are larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

Next, regarding the Z-direction, in the case where one liner is formed of Cu, a ratio of the gap to the size of the Cu-liner in the Z-direction is determined so as to be in the range of 0.0007 to 0.00839. In addition, in the case where one liner is formed of Ta, a ratio of the gap to the size of the Ta-liner in the Z-direction is determined so as to be in the range of 0.0007 to 0.0032.

Here, the gap G11Z (the sum of G12Z, G13Z, G14Z, G15Z, and G16Z) in the hearth liner 11 is determined by the numbers of the Cu-liner and the Ta-liner accommodated in the hearth liner 11 and the above-described gap ratios. Specifically, the value of the gap is obtained by multiplying the numbers of the Cu-liner by the above-described gap ratio (0.0007 to 0.00839). Similarly, the value of the gap is obtained by multiplying the numbers of the Ta-liner by the above-described gap ratio (0.0007 to 0.0032). The gap G11Z is the value determined by adding the above obtained values.

In the Z-direction in which the liners 12 to 16 align, each of the ratios RZ12, RZ13, RZ14, RZ15, and RZ16 may be lower than the lower limit of the above-mentioned range, for example, may be determined such that the liners 12 to 16 can be accommodated in the hearth liner 11 so as to have a gap of larger than 0 mm. However, in this case, since there is a concern that the liners 12 to 16 cannot be accommodated in the hearth liner 11 depending on change in shape with the passage of time or machining accuracy, it is preferable that each of the ratios RZ12, RZ13, RZ14, RZ15, and RZ16 be in the above-mentioned range. Similarly, in the case where each of the ratios RZ12, RZ13, RZ14, RZ15, and RZ16 is larger than the upper limit of the above-mentioned range, the liners 12 to 16 may not come into contact with the inside of the hearth liner 11 when the liners are thermally-expanded, the liners cannot to sufficiently cooled down, and therefore it is not preferable.

In the evaporator 10 according to the embodiment, as shown in FIG. 6, in the case where the three liners 12, 14, and 16 formed of Ta and the two liners 13 and 15 formed of Cu are adjacently and alternately disposed inside the hearth liner 11 in the Z-direction, it is preferable that the gaps G12X to G16X and G11Z to G16Z in the non-heated state be determined as follows.

Specifically, in the example shown in FIG. 6, the following configuration is determined so as to correspond to the constituent materials of Cu and Ta.

A ratio of the gap G12X to the width of the outer shape in the X-direction of the liner 12 formed of Ta is determined so as to be in the range of 0.0007 to 0.0032. The gap G12X is determined so as to be in the range of 0.05 mm to 0.23 mm.

A ratio of the gap G13X to the width of the outer shape in the X-direction of the liner 13 formed of Cu is determined so as to be in the range of 0.0007 to 0.00839. The gap G13X is determined so as to be in the range of 0.05 mm to 0.60 mm.

A ratio of the gap G14X to the width of the outer shape in the X-direction of the liner 14 formed of Ta is determined so as to be in the range of 0.0007 to 0.0032. The gap G14X is determined so as to be in the range of 0.05 mm to 0.23 mm.

A ratio of the gap G15X to the width of the outer shape in the X-direction of the liner 15 formed of Cu is determined so as to be in the range of 0.0007 to 0.00839. The gap G15X is determined so as to be in the range of 0.05 mm to 0.60 mm.

A ratio of the gap G16X to the width of the outer shape in the X-direction of the liner 16 formed of Ta is determined so as to be in the range of 0.0007 to 0.0032. The gap G16X is determined so as to be in the range of 0.05 mm to 0.23 mm.

A ratio of the gap G11Z to the sum of the lengths of the outer shapes in the Z-direction of the liners 12 to 16 is determined so as to be in the range of 0.0035 to 0.0264 so as to correspond to the above-described ratios regarding Cu and Ta. The gap G11Z is determined so as to be in the range 0.25 mm to 1.89 mm.

A ratio of the gap G12Z to the length of the outer shape in the Z-direction of the liner 12 formed of Ta is determined so as to be in the range of 0.0007 to 0.0032. The gap G12Z is determined so as to be in the range of 0.05 mm to 0.23 mm.

A ratio of the gap G13Z to the length of the outer shape in the Z-direction of the liner 13 formed of Cu is determined so as to be in the range of 0.0007 to 0.00839. The gap G13Z is determined so as to be in the range of 0.05 mm to 0.60 mm.

A ratio of the gap G14Z to the length of the outer shape in the Z-direction of the liner 14 formed of Ta is determined so as to be in the range of 0.0007 to 0.0032. The gap G14Z is determined so as to be in the range of 0.05 mm to 0.23 mm.

A ratio of the gap G15Z to the length of the outer shape in the Z-direction of the liner 15 formed of Cu is determined so as to be in the range of 0.0007 to 0.00839. The gap G15Z is determined so as to be in the range of 0.05 mm to 0.60 mm.

A ratio of the gap G16Z to the length of the outer shape in the Z-direction of the liner 16 formed of Ta is determined so as to be in the range of 0.0007 to 0.0032. The gap G16Z is determined so as to be in the range of 0.05 mm to 0.23 mm.

In the evaporator 10 according to the embodiment, as shown in FIG. 7, in the case where the five liners 12 to 16 formed of tantalum are adjacently disposed inside the hearth liner 11 in the Z-direction, it is preferable that the gaps G12X to G16X and G11Z to G16Z in the non-heated state be determined as follows.

Specifically, in the example shown in FIG. 7, the following configuration is determined so as to correspond to the constituent material of Ta.

A ratio of the gap G12X to the width of the outer shape in the X-direction of the liner 12 formed of Ta is determined so as to be in the range of 0.0007 to 0.0032. The gap G12X is determined so as to be in the range of 0.05 mm to 0.23 mm.

A ratio of the gap G13X to the width of the outer shape in the X-direction of the liner 13 formed of Ta is determined so as to be in the range of 0.0007 to 0.0032. The gap G13X is determined so as to be in the range of 0.05 mm to 0.23 mm.

A ratio of the gap G14X to the width of the outer shape in the X-direction of the liner 14 formed of Ta is determined so as to be in the range of 0.0007 to 0.0032. The gap G14X is determined so as to be in the range of 0.05 mm to 0.23 mm.

A ratio of the gap G15X to the width of the outer shape in the X-direction of the liner 15 formed of Ta is determined so as to be in the range of 0.0007 to 0.0032. The gap G15X is determined so as to be in the range of 0.05 mm to 0.23 mm.

A ratio of the gap G16X to the width of the outer shape in the X-direction of the liner 16 formed of Ta is determined so as to be in the range of 0.0007 to 0.0032. The gap G16X is determined so as to be in the range of 0.05 mm to 0.23 mm.

A ratio of the gap G11Z to the sum of the lengths of the outer shapes in the Z-direction of the liners 12 to 16 formed of Ta is determined so as to be in the range of 0.0035 to 0.016. The gap G11Z is determined so as to be in the range of 0.25 mm to 1.15 mm.

A ratio of the gap G12Z to the length of the outer shape in the Z-direction of the liner 12 formed of Ta is determined so as to be in the range of 0.0007 to 0.0032. The gap G12Z is determined so as to be in the range of 0.05 mm to 0.23 mm.

A ratio of the gap G13Z to the length of the outer shape in the Z-direction of the liner 13 formed of Ta is determined so as to be in the range of 0.0007 to 0.0032. The gap G13Z is determined so as to be in the range of 0.05 mm to 0.23 mm.

A ratio of the gap G14Z to the length of the outer shape in the Z-direction of the liner 14 formed of Ta is determined so as to be in the range of 0.0007 to 0.0032. The gap G14Z is determined so as to be in the range of 0.05 mm to 0.23 mm.

A ratio of the gap G15Z to the length of the outer shape in the Z-direction of the liner 15 formed of Ta is determined so as to be in the range of 0.0007 to 0.0032. The gap G15Z is determined so as to be in the range of 0.05 mm to 0.23 mm.

A ratio of the gap G16Z to the length of the outer shape in the Z-direction of the liner 16 formed of Ta is determined so as to be in the range of 0.0007 to 0.0032. The gap G16Z is determined so as to be in the range of 0.05 mm to 0.23 mm.

A method of forming a film in the deposition apparatus 100 according to the embodiment will be described.

Particularly, as the following film formation method, a method of forming a compound film (electrolyte film) that serves as a thin film and contains nitrogen and lithium on a web-shaped base member F will be described. Specifically, a method of forming a compound film formed of LiPON will be described.

Since LiPON has not only ion conductively but also non-conductively with respect to electrons and therefore is suitable to batteries or solid-state electrolytes for use of secondary batteries. Therefore, as a typical layer system to be used, a LiPON layer having a layer thickness of approximately several μm can be formed.

Deposition of a LiPON layer using an electron-beam coating method is possible. In this case, lithium phosphate (LiPO) is evaporated in the atmosphere having nitrogen-containing reactant gas by an electron beam that directly acts on the vapor-deposition material.

An evaporation material containing at least lithium element, phosphorus, and oxygen is evaporated in a thermal evaporation apparatus inside the vacuum chamber, and therefore a LiPON layer is deposited on the substrate.

At this time, the vapor-deposition material is directly evaporated by an electron beam. At the same time, a component containing nitrogen, preferably, nitrogen-containing reactant gas is introduced into the vacuum chamber, plasma penetrates through the evaporated particle cloud rising up therein.

As a nitrogen-containing reactant gas, for example, a gas such as ammonia (NH$_3$), laughing gas (NO$_2$), or nitrogen (N$_2$) is suitable. With respect to the introduction of nitrogen-containing reactant gas, for example, a precursor (precursors) containing nitrogen may also be introduced into the vacuum chamber.

Regarding the film formation in the deposition apparatus 100, firstly, the inside of the vacuum chamber 110 is vacuumed, and the film formation unit 120, the transfer unit 130, and the collection unit 160 are maintained in a predetermined degree of vacuum.

Additionally, the transfer mechanism 170 supporting the base member F is driven, and the base member F is fed from the unwinding roller 171 to the rewinding roller 173. In the film formation unit 120, the base member F is fed (moved) in the X-direction.

Note that, as described below, positive electrodes, power collectors, or the like are formed on a predetermined region on the base member F in advance.

With regard to the film formation unit 120, a gas containing nitrogen is introduced from the gas supplier SO into the inside of the film formation unit 120.

Moreover, in the film formation unit 120, electric power for generating plasma is supplied to the main roller 172 from the plasma-generating power supply 55 connected thereto. At the same time, in the film formation unit 120, due to the electric power supplied from the power supply connected thereto, the magnet 30 generates a magnetic flux.

Consequently, plasma is generated in the plasma generation region.

In the evaporator 10 of the film formation unit 120, each of the liners 12 to 16 is heated by, for example, an electron beam or the like, evaporates each of the vapor-deposition materials, and generates a vaporization flow of the vapor-deposition material containing lithium (material for forming a film) that is emitted toward the base member F on the main roller 172.

At this time, a heating condition of the vapor-deposition material accommodated in each of the liners 12 to 16 is determined depending on a vapor pressure, a sublimation temperature, an amount of evaporation, the ratio necessary for codeposition, input power necessary for codeposition, or the like of each vapor-deposition material.

Furthermore, the region of the base member F to which the vaporization flow of the vapor-deposition material containing lithium (vapor-deposition material) reaches is regulated by the opening 21 of the shield 20.

At the region near the opening 21 of the shield 20, the deposition particles containing lithium that are activated by nitrogen gas converted into plasma are deposited on the surface of the base member F as an electrolyte layer containing nitrogen.

In the heated state of codeposition, a temperature of each of the liners 12 to 16 increases. In accordance with this, the liners 12 to 16 are thermally expanded so as to correspond to coefficients of thermal expansion the respective materials. As a result, each of the walls 12a to 16a of the liners 12 to 16 comes into contact with the wall portion 11a of the hearth liner 11 or the walls 12a to 16a in a state where they face each other.

That is, each of the liners 12 to 16 is thermally-expanded so that each of the gaps G12X to G16Z becomes zero inside the hearth liner 11.

Each of the walls 12a to 16a of the liners 12 to 16 is brought into close contact with the surrounding member which is adjacent and opposed to the walls.

At this time, each of the liners 12 to 16 comes into contact with the hearth liner 11 cooled by the cooler 18 and is thereby cooled down due to heat transfer from the walls 12a to 16a to the wall portion 11a and the bottom portion 11b. Additionally, each of the liners 12 to 16 is cooled down by heat transfer from the adjacent walls 12a to 16a of the liners 12 to 16.

Accordingly, the temperature of each of the liners 12 to 16 is maintained to be in a temperature range not to chemically react with the vapor-deposition material thereinside. At the same time, the vapor-deposition material located at the center of the opening of each of the liners 12 to 16 is molten, evaporates or sublimates. The vapor-deposition material located close to the peripheral edge of the opening of the wall portion 12a to 16a is not molten or a state where the temperature thereof gradually increases is maintained.

Accordingly, the deposition apparatus 100 according to the embodiment, codeposition can be carried out without generation of contamination, change of a compositional ratio, or the like.

Consequently, in the deposition apparatus 100 according to the embodiment, it is possible to control the composition of the compound film by the liners 12 to 16 in which the vapor-deposition materials different from each other are alternately disposed, and it is possible to manufacture the compound film having improved film characteristics.

In the invention, the combination of the configurations of the various embodiments as mentioned above can also be adopted.

Industrial Applicability

As an available example of the invention, an apparatus can be adopted which carries out: film formation of an electrolyte layer such as LiPON or the like which contains lithium and nitrogen by use of plasma containing a vapor-deposition material containing lithium and nitrogen; or film formation of a positive-electrode material such as LCO or the like which contains lithium and oxygen by use of plasma containing a vapor-deposition material containing lithium and oxygen.

DESCRIPTION OF REFERENCE NUMERALS

| | |
|---|---|
| 100 | deposition apparatus |
| 10 | evaporator |
| 11 | hearth liner |
| 11a to 16a | wall portion |
| 12 to 16 | liner |
| 18 | cooler |
| 20 | shield (shielding member) |
| 21 | opening |
| 120 | film formation unit |
| 170 | transfer mechanism (substrate transfer unit) |
| 172 | main roller |
| F | base member (substrate) |
| G12X to G16X, G11Z to G16Z | gap |

**Claims**

1. An evaporator that is heated by an electron beam in vacuum, evaporates or sublimates a vapor-deposition material, and forms a lithium-containing compound coating on a surface of a substrate in transfer by codeposition, the evaporator comprising:

   a hearth liner that includes a cooler; and
   a plurality of liners that are accommodated in the hearth liner, each of which has the vapor-deposition material thereinside.

2. The evaporator according to claim 1, wherein

   each of the liners has a wall facing a surrounding member that serves as an adjacent liner or the hearth liner, and the liners are disposed inside the hearth liner such that the wall comes into contact with the surrounding member in a heated state and such that the wall is separated from the surrounding member with a gap interposed therebetween in a non-heated state.

3. The evaporator according to claim 2, wherein

   each of the liners is formed in a rectangular shape in plan view, and
   the liners are disposed inside the hearth liner and adjacent to each other in a direction orthogonal to a movement direction of the substrate.

4. The evaporator according to claim 3, wherein
a material used to form each of the liners is a material that does not react with the vapor-deposition material in a heated state.

5. The evaporator according to claim 4, wherein
of the liners, a liner accommodating lithium as the vapor-deposition material is formed of tantalum.

6. The evaporator according to claim 4, wherein
of the liners, a liner accommodating the vapor-deposition material not containing lithium is formed of copper.

7. The evaporator according to claim 4, wherein
of the liners, a liner accommodating the vapor-deposition material containing lithium is formed of tantalum.

8. The evaporator according to claim 4, wherein
of the liners, a liner accommodating the vapor-deposition material containing lithium is formed of copper.

9. The evaporator according to any one of claims 2 to 8, wherein

   of the liners, a liner formed of copper is disposed inside the hearth liner, and
   in a non-heated state, a ratio of a size of the gap to an outer size of the liner is in a range of 0.0007 to 0.00839.

10. The evaporator according to any one of claims 2 to 8, wherein

    of the liners, a liner formed of tantalum is disposed inside the hearth liner, and
    in a non-heated state, a ratio of a size of the gap to an outer size of the liner is in a range of 0.0007 to 0.0032.

11. The evaporator according to any one of claims 2 to 8, wherein

    of the liners, five liners formed of copper are disposed inside the hearth liner, and
    in a non-heated state, a ratio of a sum of sizes of the gaps to a sum of outer sizes of the liners in a liner arrangement direction is in a range of 0.0035 to 0.042.

12. The evaporator according to any one of claims 2 to 8, wherein

    of the liners, three liners formed of copper and two liners formed of tantalum are disposed inside the hearth liner, and
    in a non-heated state, a ratio of a sum of sizes of the gaps to a sum of outer sizes of the liners in a liner arrangement direction is in a range of 0.0035 to 0.0316.

13. The evaporator according to any one of claims 2 to 8, wherein

    of the liners, two liners formed of copper and three liners formed of tantalum are disposed inside the hearth liner, and
    in a non-heated state, a ratio of a sum of sizes of the gaps to a sum of outer sizes of the liners in a liner arrangement direction is in a range of 0.0035 to 0.0264.

14. The evaporator according to any one of claims 2 to 8, wherein

    of the liners, five liners formed of tantalum are disposed inside the hearth liner, and
    in a non-heated state, a ratio of a sum of sizes of the gaps to a sum of outer sizes of the liners in a liner arrangement direction is in a range of 0.0035 to 0.016.

15. A deposition apparatus comprising:

    a chamber in which a substrate is movable in vacuum;
    a substrate transfer unit that transfers the substrate;
    the evaporator according to any one of claims 1 to 14; and
    an electron beam source that irradiates the evaporator with an electron beam.

# FIG. 1

# FIG. 2

# FIG. 3

EP 4 098 768 A1

# FIG. 4

LCO

# FIG. 5

LCO

# FIG. 6

LiPON

# FIG. 7

LiPON

**INTERNATIONAL SEARCH REPORT**

International application No.

PCT/JP2020/047930

#### A. CLASSIFICATION OF SUBJECT MATTER
Int. Cl. C23C14/24(2006.01)i
FI: C23C14/24 A

According to International Patent Classification (IPC) or to both national classification and IPC

#### B. FIELDS SEARCHED
Minimum documentation searched (classification system followed by classification symbols)
Int. Cl. C23C14/24

Documentation searched other than minimum documentation to the extent that such documents are included in the fields searched
Published examined utility model applications of Japan     1922-1996
Published unexamined utility model applications of Japan   1971-2021
Registered utility model specifications of Japan           1996-2021
Published registered utility model applications of Japan   1994-2021

Electronic data base consulted during the international search (name of data base and, where practicable, search terms used)

#### C. DOCUMENTS CONSIDERED TO BE RELEVANT

| Category* | Citation of document, with indication, where appropriate, of the relevant passages | Relevant to claim No. |
|---|---|---|
| Y | JP 2006-70309 A (HOYA CORP.) 16 March 2006, | 1, 15 |
| A | paragraphs [0017]-[0030], fig. 1, 4 | 2-14 |
| Y | JP 2012-233211 A (NIHON DEMPA KOGYO CO., LTD.) 29 | 1, 15 |
| A | November 2012, paragraphs [0007], [0008], [0027], [0028], fig. 2, 8 | 2-14 |
| Y | WO 2009/047879 A1 (PANASONIC CORP.) 16 April 2009, | 1, 15 |
| A | paragraphs [0103]-[0111], [0121], [0122], fig. 4 | 2-14 |
| A | JP 2008-57000 A (FUCHITA NANO GIKEN KK) 13 March 2008, entire text, all drawings | 1-15 |

☐ Further documents are listed in the continuation of Box C.        ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21.01.2021 | 02.02.2021 |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

| International application No. |
|---|
| PCT/JP2020/047930 |

| Patent Documents referred to in the Report | Publication Date | Patent Family | Publication Date |
|---|---|---|---|
| JP 2006-70309 A | 16.03.2006 | (Family: none) | |
| JP 2012-233211 A | 29.11.2012 | US 2013/0107369 A1 paragraphs [0010], [0011], [0037], [0038], fig. 2, 8 CN 102758180 A TW 201250028 A | |
| WO 2009/047879 A1 | 16.04.2009 | US 2010/0196623 A1 paragraphs [0159]- [0167], [0171]- [0180], fig. 4 CN 101821422 A KR 10-2010-0084649 A | |
| JP 2008-57000 A | 13.03.2008 | (Family: none) | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020011830 A
- JP 2003277917 A